# FASCICULE DE BREVET EUROPEEN

(11) **EP 2 368 414 B1**
(45) Date de publication et mention de la délivrance du brevet: **11.12.2013**
(21) Numéro de dépôt: 09803795.5
(22) Date de dépôt: 21.12.2009
(51) Int. Cl.: H05K 7/14, H05K 1/02

(54) **CARTE ELECTRIQUE MODULAIRE POUR COMPOSANTS DE PUISSANCE**
MODULARE ELEKTRISCHE KARTE FÜR STROMKOMPONENTEN
MODULAR ELECTRICAL CARD FOR POWER COMPONENTS

(30) Priorité: 24.12.2008 FR 0807453
(43) Date de publication de la demande: 28.09.2011
(73) Titulaire: SAGEM Défense Sécurité, 75015 Paris (FR)
(72) Inventeur: MERLET, Etienne, F-75015 Paris (FR)
(74) Mandataire: Lavialle, Bruno François Stéphane
(86) Numéro de dépôt international: PCT/FR2009/001467
(87) Numéro de publication internationale: WO 2010/072919

(56) Documents cités:
- EP-A1- 1 615 317
- FR-A1- 2 805 961
- FR-A1- 2 826 544
- US-A1- 2003 133 282
- US-A1- 2006 052 914

## Description

La présente invention concerne une carte électrique modulaire, plus particulièrement bien que non exclusivement une carte de module de disjoncteur.

### ARRIERE PLAN DE L'INVENTION

Compte tenu de l'usage croissant des commandes électriques dans les véhicules, qu'il s'agisse de véhicules terrestres ou aériens, il est maintenant courant d'équiper ces véhicules de boîtiers électriques contenant des cartes électriques incluant des composants de puissance. Pour faciliter la maintenance du boîtier électrique, les fonctions sont généralement réalisées par des composants regroupés selon des modules de puissance comprenant chacun des composants de puissance et des composants de commande (voir par exemple FR 2 805 961).

Dans les cartes existantes, les bus de puissance sont généralement réalisés sous forme de circuits multi-couche, chaque module étant alimentée par un plan conducteur réalisé dans une couche. Cette disposition permet d'adapter la topographie des plans d'alimentation de puissance à la disposition des composants de puissance sur la carte.

Toutefois, les courants qui sont amenés à passer dans les modules de puissance peuvent atteindre des intensités importantes, par exemple plusieurs dizaines d'ampères. De tels courants provoquent un échauffement des conducteurs et les dispositifs actuels assurent une mauvaise diffusion de la chaleur, de sorte que la température à l'intérieur d'une carte électrique peut atteindre des valeurs critiques, en particulier lorsque la carte électrique est monté sur un avion prévu pour voler à des altitudes élevées ou l'air est raréfié, ou encore dans le cas d'une défaillance du dispositif de ventilation du boîtier électrique supportant la carte électri-que.

### OBJET DE L'INVENTION

Un but de l'invention est de proposer une carte électrique entièrement modulaire et configurable, et dont les modules ont une structure permettant un refroidissement amélioré.

### RESUME DE L'INVENTION

En vue de la réalisation de ces buts on propose, selon l'invention, une carte électrique comprenant des modules de puissance constitués de composants de puissance et de composants de commande portés par des barrettes fixées sur une plaque support comportant une plaque de masse électrique, les composants de puissance étant reliés d'une part à des bus de commande et, d'autre part à des bus de puissance portés par la plaque support et s'étendant selon une couche adjacente à la plaque de masse électrique.

Ainsi la maintenance de la carte électrique contenant des composants de puissance est facilitée et la plaque de masse électrique agit comme un puits de chaleur. En raison de ses grandes dimensions, elle assure donc une diffusion rapide de la chaleur.

De préférence, la plaque support comporte également, une plaque métallique de renfort mécanique sur un coté des bus de puissance opposé à la plaque de masse électrique.

La plaque de renfort métallique agit également comme un puits de chaleur et possède de grandes dimensions lui permettant d'assurer une diffusion rapide de la chaleur.

Selon une version avantageuse de l'invention, les bus d'alimentation de puissance s'étendent selon une couche unique adjacente à une face de la plaque de masse et les bus de liaison s'étendent sur une face de la plaque de masse opposée aux bus de puissance.

Ainsi, la plaque de masse assure non seulement la diffusion de la chaleur générée par les composants de puissance, mais également une protection thermique et électromagnétique des bus de liaison et des composants de commande associés.

Selon d'autres caractéristiques avantageuses de l'invention, les composants de puissance sont portés par des barrettes s'étendant perpendiculairement à la plaque de masse et disposées pour délimiter avec la plaque de masse des canaux allongés, les composants de commande sont portés par des barrettes s'étendant dans les canaux en étant espacés des barrettes de puissance, de préférence, les composants de commandes sont portés par des barrettes de commande s'étendant selon une direction axiale des canaux à mi-distance des extrémités des canaux. Ainsi, les composants de commande sont disposés au milieu du flux d'air circulant dans les canaux, ce qui minimise l'échauffement résultant de la transmission de chaleur en provenance des composants de puissance par conduction ou par radiation.

### BREVE DESCRIPTION DES DESSINS

D'autres caractéristiques et avantages de l'invention apparaîtront à la lecture de la description qui suit d'un mode de réalisation particulier non limitatif de la carte selon l'invention, en référence aux figures ci-jointes parmi lesquelles :
- la figure 1 est une vue en perspective schématique d'une carte électrique selon l'invention,
- la figure 2 est une vue en perspective analogue à celle de la figure 1 avec arrachement partiel de certaines couches.

### DESCRIPTION DETAILLEE DE L'INVENTION

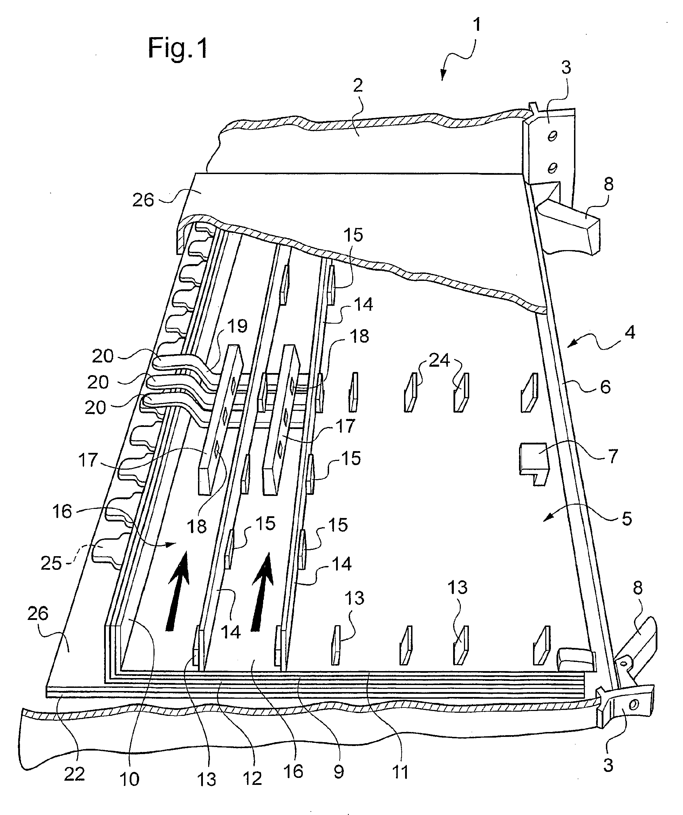

En référence à la figure 1, le boîtier électrique généralement désigné en 1 comprend une enveloppe extérieure 2 dans laquelle sont fixés des rails supports 3 auxquels sont fixés des cartes 4 dont une seule a été représentée sur les figures.

Dans le mode de réalisation illustré le boîtier a été représenté couché sur un coté. Chaque carte 4 comporte une plaque support 5 qui, lorsqu'elle est montée, s'étend verticalement dans le boîtier. Sur son bord correspondant au rail support 3, chaque carte est équipée d'une paroi avant 6 fixée à la plaque support 5 perpendiculairement à celle-ci par des blocs d'assemblage 7 et équipé d'organes de verrouillage 8 coopérant avec les rails supports 3.

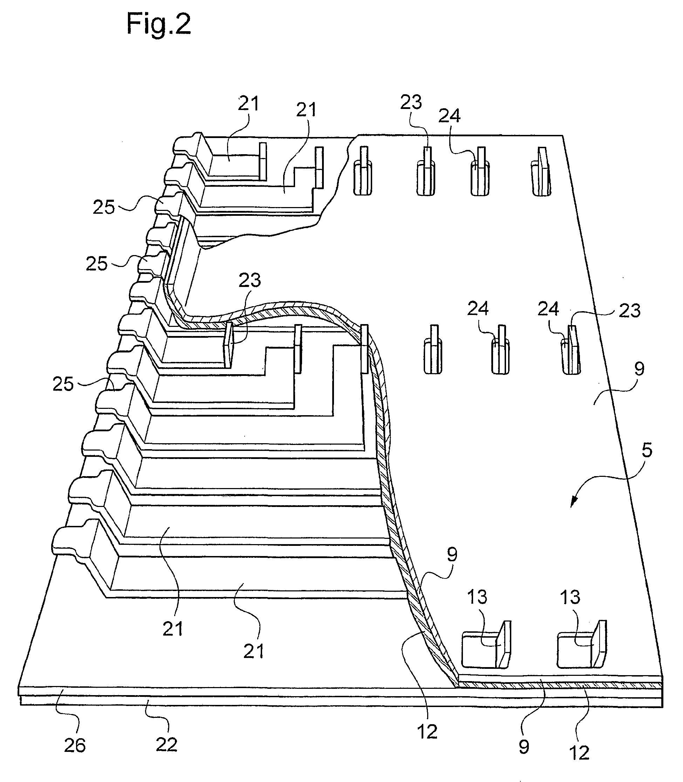

La plaque support 5 comprend une plaque métallique de masse électrique 9 mieux visible sur la figure 2 sur laquelle elle a été représentée dégagée des barrettes de composants et des bus de liaison avec les composants de commande, et a été partiellement écorchée pour mieux montrer la structure des bus de puissance. Le long de son bord arrière, la plaque de masse électrique 9 est repliée en L. La partie repliée 10 forme la paroi arrière de la carte 4. La plaque de masse électrique 9 est prise en sandwich entre deux couches en matériau isolant 11 et 12.

A une de ses extrémités la plaque de masse électrique 9 comporte des pattes de masse électrique 13 découpées dans la plaque de masse électrique 9 et repliées perpendiculairement à celle-ci pour être en saillie par rapport à une face de la plaque de masse électrique 9.

La plaque support 5 est équipée de barrettes de puissance 14 portant des composants de puissance 15 et raccordée aux pattes de masse électrique 13 pour s'étendre perpendiculairement à la plaque support 5 selon une direction longitudinale de celle-ci de façon à délimiter des canaux longitudinaux 16 dans lesquels l'air peut circuler, comme illustré par des flèches en traits épais sur la figure 1, par convection naturelle ou par ventilation forcée au moyen d'un dispositif de ventilation non représenté.

Selon un aspect de l'invention, chaque module comprend également des barrettes de commande 17 séparées des barrettes de puissance 14 et portant des composants de commande 18. Les barrettes de commande s'étendent de préférence à mi-distance des extrémités des canaux délimités par les barrettes de puissance. Les barrettes de commande forment ainsi une restriction de la section du conduit, ce qui provoque une accélération locale du flux de refroidissement. Les barrettes de commande 17 sont reliées par des bus de liaison 19 équipés à une extrémité de pattes de liaison 20 permettant de relier (au moyen de connecteurs non représentés) les bus de liaison 19 avec des circuits de commande extérieurs au module. Ces bus de liaison 19 peuvent être réalisés sous forme d'une carte électronique conventionnelle, équipée d'un connecteur mâle comportant les pattes de liaison 20.

Ainsi que cela est illustré par la figure 2, la plaque support 5 comporte ici des bus de puissance 21 se présentant sous forme de bandes conductrices prises en sandwich entre la couche électriquement isolante 12 et une couche électriquement isolante 26 recouvrant une plaque métallique de renfort mécanique 22 sur sa face interne, du côté des bus de puissance 21. Dans le mode de réalisation préféré illustré, les bus de puissance 21 s'étendent selon une couche unique immédiatement adjacente d'une part à la plaque de masse électrique 9 dont elle est seulement séparée par la couche isolante 12, et d'autre part à la plaque de renfort mécanique 22 dont elle est seulement séparée par la couche isolante 26. Les bus de puissance 21 ont des formes en L imbriquées les unes dans les autres et comportent à une extrémité des pattes de liaison de puissance 23 qui s'étendent à travers des ouvertures 24 de la plaque de masse électrique 9 et sont reliées aux barrettes de puissance 14.

Dans le mode de réalisation préféré illustré, les pattes de liaison de puissance 24 sont alignées tant dans la direction longitudinale que dans la direction transversale de la plaque support 5 de sorte que les barrettes de puissance 14 peuvent avoir une structure identique quelle que soit la fonction qu'elles réalisent, ce qui simplifie la modularité et le montage d'un module.

A l'extrémité opposée aux pattes de liaison de puissance 23, les bus de puissance 21 sont équipés de pattes de liaison 25 avec un connecteur extérieur non représenté.

On notera que les bus de commande 19 s'étendent sur une face de la plaque de masse électrique 9 opposée au bus de puissance 21. Ainsi, la chaleur transmise par les bus de puissance 21 est dissipée par la plaque de masse électrique 9 et la plaque de renfort mécanique 22 de sorte que les bus de commande 19 ainsi que les organes de commande 18 qui leur sont associés sont protégés contre un échauffement excessif. En outre, la plaque de masse électrique 9 forme un écran électromagnétique entre les bus de puissance 21 et les bus de commande 19, et la plaque de renfort mécanique 22 forme un écran électromagnétique entre l'ensemble de la carte électronique et son environnement extérieur au sein du boîtier 1.

Le module est fermé par un capot en L 26.

Bien entendu, l'invention n'est pas limitée au mode de réalisation préféré illustré et est susceptible de variantes de réalisation qui apparaîtront à l'homme de métier sans sortir du cadre de l'invention tel que défini par les revendications.

En particulier, bien que l'invention ait été illustrée avec des bus de puissance s'étendant selon une couche unique, on peut prévoir de réaliser une plaque support dans laquelle les bus de puissance s'étendent selon deux couches de part et d'autre de la plaque de masse afin d'utiliser la plaque de masse comme radiateur. Dans ce cas il est préférable de regrouper les composants de commande dans un module séparé.

Bien que les bus de puissance 21 aient été illustrés sous forme de bande en L, ils peuvent être réalisés selon des conducteurs de forme quelconque.

Bien que la plaque support ait été représentée en forme de L de façon à former une paroi arrière du module, on peut prévoir une plaque support plane à laquelle est fixée une paroi arrière du module.

Bien que les pattes de masse électrique 13 aient été illustrées regroupées à une extrémité de la plaque de masse électrique 9, les pattes de masse électrique 13 pourraient être réalisées dans la partie centrale ou selon une disposition quelconque sur la carte.

## Revendications

1. Carte électrique (4) comprenant des modules de puissance constitués de composants de puissance (15) et de composants de commande (18) **caractérisé en ce que** les composants de puissance (15) et les composants de commande (18) sont portés par des barrettes (14 ; 17) fixées sur une plaque support (5) comportant une plaque de masse électrique (9), les composants de puissance (15) étant reliés d'une part à des bus de commande (19), et d'autre part à des bus de puissance (21) portés par la plaque support (5) et s'étendant selon une couche adjacente à la plaque de masse électrique.

2. Carte électrique selon la revendication 1, **caractérisée en ce que** la plaque support (5) comporte également, une plaque métallique (22) de renfort mécanique sur un coté des bus de puissance opposé à la plaque de masse électrique (9).

3. Carte électrique selon la revendication 1, **caractérisée en ce que** les bus de puissance (21) s'étendent selon une couche unique adjacente à une face de la plaque de masse électrique (9) et **en ce que** les bus de liaison (19) s'étendent sur une face de la plaque de masse électrique (9) opposée aux bus de puissance (21).

4. Carte électrique selon la revendication 1, **caractérisée en ce que** les composants de puissance (15) sont portés par des barrettes de puissance (14) s'étendant perpendiculairement à la plaque de masse électrique (9) et disposées pour délimiter avec la plaque de masse électrique des canaux allongés (16)

5. Carte électrique selon la revendication 4, **caractérisée en ce que** les composants de commande (18) sont portés par des barrettes de commande (17) s'étendant dans les canaux (16) délimités par les barrettes de puissance en étant espacées de celles-ci.

6. Carte électrique selon la revendication 4, **caractérisée en ce que** les composants de commande (18) sont portés par des barrettes de commande (17) s'étendant selon une direction axiale des canaux (16).

7. Carte électrique selon la revendication 6, **caractérisée en ce que** les barrettes de commande (17) s'étendent à mi-distance des extrémités des canaux.

8. Carte électrique selon la revendication 1, **caractérisée en ce que** les bus de puissance (21) comprennent des bandes adjacentes les unes aux autres ayant des extrémités formant des pattes en saillie qui sont alignées tant dans une direction longitudinale que dans une direction transversale de la plaque support (5).

9. Carte électrique selon la revendication 8, **caractérisée en ce que** les bus de puissance ont des formes en L imbriquées les unes dans les autres.

10. Carte électrique selon la revendication 1, **caractérisée en ce que** la plaque support (5) a une forme en L dont une partie (10) forme une paroi arrière du module de puissance.

## Patentansprüche

1. Elektrische Karte (4), die Leistungsmodule umfasst, die aus Leistungskomponenten (15) und Steuerkomponenten (18) gebildet sind, **dadurch gekennzeichnet, dass** die Leistungskomponenten (15) und die Steuerkomponenten (18) von Leisten (14 ; 17) getragen werden, die auf einer Trägerplatte (5), die eine Platte mit elektrischer Masse (9) umfasst, befestigt sind, wobei die Leistungskomponenten (15) einerseits mit Steuerbussen (19) und andererseits mit Leistungsbussen (21) verbunden sind, die von der Trägerplatte (5) getragen werden und sich entlang einer zur Platte mit elektrischer Masse benachbarten Schicht erstrecken.

2. Elektrische Karte nach Anspruch 1, **dadurch gekennzeichnet, dass** die Trägerplatte (5) auf einer Seite der Leistungsbusse, die sich gegenüber der Platte mit elektrischer Masse (9) befindet, ebenfalls eine Metallplatte (22) zur mechanischen Verstärkung umfasst.

3. Elektrische Karte nach Anspruch 1, **dadurch gekennzeichnet, dass** sich die Leistungsbusse (21) entlang einer einzigen Schicht erstrecken, die benachbart zu einer Seite der Platte mit elektrischer Masse (9) ist, und dass sich die Verbindungsbusse (19) über eine den Leistungsbussen (21) entgegengesetzte Seite der Platte mit elektrischer Masse (9) erstrecken.

4. Elektrische Karte nach Anspruch 1, **dadurch gekennzeichnet, dass** die Leistungskomponenten (15) von Leistungsleisten (14) getragen werden, die sich senkrecht zur Platte mit elektrischer Masse (9) erstrecken und so angeordnet sind, dass sie mit der Platte mit elektrischer Masse langgestreckte Kanäle (16) begrenzen.

5. Elektrische Karte nach Anspruch 4, **dadurch gekennzeichnet, dass** die Steuerkomponenten (18) von Steuerleisten (17) getragen werden, die sich in den durch die Leistungsleisten begrenzten Kanäle erstrecken, wobei sie von diesen beabstandet sind.

6. Elektrische Karte nach Anspruch 4, **dadurch gekennzeichnet, dass** die Steuerkomponenten (18) von Steuerleisten (17) getragen werden, die sich entlang (16) einer axialen Richtung der Kanäle (16) erstrecken.

7. Elektrische Karte nach Anspruch 6, **dadurch gekennzeichnet, dass** sich die Steuerleisten (17) in der Mitte der Kanalränder erstrecken.

8. Elektrische Karte nach Anspruch 1, **dadurch gekennzeichnet, dass** die Leistungsbusse (21) einander benachbarte Bänder mit Enden umfassen, die überstehende Lappen bilden, die sowohl in eine Längsrichtung als auch in eine Richtung quer zur Trägerplatte (5) ausgerichtet sind.

9. Elektrische Karte nach Anspruch 8, **dadurch gekennzeichnet, dass** die Leistungsbusse eine L-Form haben und ineinander verschachtelt sind.

10. Elektrische Karte nach Anspruch 1, **dadurch gekennzeichnet, dass** die Trägerplatte (5) eine L-Form hat, bei der ein Abschnitt (10) eine Wand hinter dem Leistungsmodul bildet.

## Claims

1. An electrical card (4) having power modules constituted by power components (15) and by control components (18), the card being **characterized in that** the power components (15) and the control components (18) are carried by strips (14; 17) fastened on a support plate (5) comprising an electrical ground plate (9), the power components (15) being connected firstly to control buses (19), and secondly to power buses (21) carried by the support plate (5) and extending in a layer adjacent to the electrical ground plate.

2. An electrical card according to claim 1, **characterized in that** the support plate (5) also includes a metal mechanical-backing plate (22) on a side of the power buses that is opposite from the electrical ground plate (9).

3. An electrical card according to claim 1, **characterized in that** the power buses (21) extend in a single layer adjacent to one of the faces of the electrical ground plate (9), and **in that** the connection buses (19) extend on a face of the electrical ground plate (9) that is opposite from the power buses (21).

4. An electrical card according to claim 1, **characterized in that** the power components (15) are carried by power strips (14) extending perpendicularly to the electrical ground plate (9) and arranged so as to co-operate with the electrical ground plate to define elongate channels (16).

5. An electrical card according to claim 4, **characterized in that** the control components (18) are carried by control strips (17) extending in the channels (16) defined by the power strips, being spaced apart therefrom.

6. An electrical card according to claim 4, **characterized in that** the control components (18) are carried by control strips (17) extending in an axial direction of the channels (16).

7. An electrical card according to claim 6, **characterized in that** the control strips (17) extend halfway from the ends of the channels.

8. An electrical card according to claim 1, **characterized in that** the power buses (21) comprise mutually adjacent straps having ends that form projecting tabs that are in alignment both in a longitudinal direction and in a transverse direction of the support plate (5).

9. An electrical card according to claim 8, **characterized in that** the power buses are of L-shapes that are mutually engaged one in another.

10. An electrical card according to claim 1, **characterized in that** the support plate (5) presents an L-shape, with a portion thereof (10) forming a rear wall of the power module.
